Europäisches Patentamt

European Patent Office

Office européen des brevets

(11) Veröffentlichungsnummer: **0 623 690 A1**

# EUROPÄISCHE PATENTANMELDUNG

(21) Anmeldenummer: **93107142.7**

(22) Anmeldetag: **03.05.93**

(51) Int. Cl.5: **C23C 16/00**

(43) Veröffentlichungstag der Anmeldung:
**09.11.94 Patentblatt 94/45**

(84) Benannte Vertragsstaaten:
**DE ES FR GB IT**

(71) Anmelder: **Keller, Klaus, Dr. Ing.**
**Haftlet 7**
**CH-4612 Wangen b. Olten (CH)**

(72) Erfinder: **Keller, Klaus, Dr. Ing.**
**Haftlet 7**
**CH-4612 Wangen b. Olten (CH)**
Erfinder: **Keller, Dirk A.**
**Knüslistrasse 17**
**CH-8004 Zürich (CH)**

(74) Vertreter: **Görg, Klaus, Dipl.-Ing. et al**
**Hoffmann, Eitle & Partner**
**Patent- und Rechtsanwälte**
**Postfach 81 04 20**
**D-81904 München (DE)**

(54) **Werkzeug mit hochbelastbaren Wirk(Arbeits-)flächen.**

(57) Für hochbelastete Reibpaarungen wird auf einem härtbaren Stahl (27), der unmittelbar an bzw. in der Oberfläche eine mit Kohlenstoff und/oder Stickstoff und/oder Bor speziell angereicherte Diffusionszone (2) besitzt, mindestens eine Hartstoffschicht (93), bestehend aus beliebig zusammengesetzten Karbiden, Nitriden, Boriden, Oxiden der Metalle der IV. bis VI. Gruppe des periodischen Systems, mittels eines Hochtemperatur-CVD-Verfahrens aufgebracht, wobei die mindestens eine Hartstoffschicht (93) durch differenzierte Keimbildungsdichte in der Diffusionszone (2) unterschiedlich rasch aufwächst. Dadurch bilden sich pro Quadratzentimeter etwa 100.000 bis 1 Million mikroskopisch kleine Flachmulden (4), deren Tiefe ca. 25% bis 40% der Gesamtschichtstärke (16) beträgt, und deren flächige Ausdehnung etwa 300 $\mu m^2$ bis 30 $\mu m^2$ umfaßt.

Figur 1

Die Erfindung betrifft ein Werkzeug mit hochbelastbaren Wirk(Arbeits-)flächen für hochbelastete Reibpaarungen mit mindestens einer schmierfilmstützenden, hydrodynamisch hochaktiven Hartstoffschicht auf härtbarem Stahl.

Hochbelastete Reibpaarungen werden in zunehmendem Maße durch wenige Mikrometer dünne Hartstoffschichten, vorwiegend bestehend aus den Karbiden, Nitriden, Oxiden und Boriden der Übergangsmetalle, der IV. bis VI. Gruppe des Periodensystems, verschleißbeständig gemacht. Diese Hartstoffe sowie die daraus bestehenden Schichten lassen sich in vielfältiger Weise miteinander kombinieren, wodurch hochdifferenzierte Schichtsysteme herstellbar werden, welche insbesondere bei offenen Tribosystemen mit extrem belasteten Arbeitsflächen, wie sie vor allem bei Maschinenwerkzeugen vorkommen, innovative Problemlösungen ermöglichen.

Die für die Abscheidung solcher Schichtsysteme in Frage kommenden Beschichtungstechniken sind CVD- und PVD-Verfahren. Sie gestatten, den Aufbau der Schichtsysteme in gewissen Grenzen zu modifizieren und auch eine belastungs- und anwendungsrelevante Susbstratbeeinflussung dem eigentlichen Beschichtungsvorgang vorausgehen zu lassen. Sofern diese Substrate aus Werkzeug- und Vergütungsstahl, Hartmetallen oder Keramiken, also aus kristallinen Werkstoffen bestehen, reagieren ihre oberflächennahe Bereiche auf solche Substratpräparationen mehr oder weniger kristallit- bzw. gefügespezifisch. Gerade die Hochtemperatur-CVD-Beschichtungstechniken verfügen hier über erheblichen verfahrenstechnischen Präparationsspielraum, weil sie dank hoher Abscheidungstemperaturen (> 800°C) nicht nur rasch verlaufende Diffusionsvorgänge, sondern (z.B. bei Stählen) auch umfangreiche Kristallumwandlungen in sich vereinigen. Solche in die Abscheidungsprozesse integrierte Präparationen erweitern die Möglichkeiten der Schichtstrukturierung und verleihen gerade den CVD-gestützten Dünnschichttechniken ein bisher wenig beachtetes Potential für anwendungsspezifisches Schichtdesign.

Trotz der hervorragenden tribotechnischen Eigenschaften der Hartstoffschichten nach Stand der Technik ist ihre Verwendung, z.B. in hochbelasteten Gleitpaarungen, ohne Schmiermittel nicht möglich. Allerdings gestatten alle Hartstoffschichten in der Regel eine gewisse Reduktion der Schmiermittelmengen, wobei jedoch eine systematische Untersuchung der Wechselwirkung zwischen Schmierstoffen und den keramikartigen, chemisch weitgehend inerten Hartstoffschichten bislang nicht erfolgte. Ersatzweise müssen deshalb tribologische Untersuchungen an Gleitpaarungen aus Festkörperkeramik herangezogen werden, welche ein verändertes Reibverhalten gegenüber fast allen Schmierstoffen signalisieren und entsprechenden Entwicklungsbedarf auch bei Hartstoffschichten aufzeigen: schichtspezifische Schmiermittel sind bisher nicht entwickelt worden.

Das technische Problem der Erfindung besteht darin, eine hydrodynamisch hochaktive Gleitpaarung zu schaffen und gleichzeitig die hartstofftypische Verschleißbeständigkeit voll auszuschöpfen.

Die Lösung dieses technischen Problems besteht darin, auf einem härtbaren Stahl, der unmittelbar an der Oberfläche eine mit Kohlenstoff und/oder Stickstoff und/oder Bor angereicherte Diffusionszone besitzt, mindestens eine Hartstoffschicht, bestehend aus Karbiden, Nitriden, Boriden, Oxiden der Metalle der IV. bis VI. Gruppe des periodischen Systems in beliebiger Zusammensetzung, mittels eines Hochtemperatur-CVD-Verfahrens aufzubringen, wobei die mindestens eine Haftstoffschicht durch differenzierte Keimbildungsdichte in bzw. auf der Diffusionszone unterschiedlich rasch aufwächst. Dadurch bilden sich etwa 100.000 bis 1 Million pro $cm^2$ mikroskopisch feine Flachmulden, deren Tiefe ca. 25% bis 40% der Gesamtschichtstärke, maximal jedoch 3 bis 4 $\mu m$, beträgt und deren flächige Ausdehnung etwa 300 $\mu m^2$ bis 30 $\mu m^2$ umfaßt.

Derartige erfindungsgemäße Schichtoberflächen bieten für Schmierstoffe generell bessere Benetzungs-, Spreitungs- und Tragbedingungen. Auf diese Weise optimierte Reibflächen machen insbesondere bei sehr hoher spezifischer Kontaktflächenbelastung im Mischreibungsbetrieb hartstoffbeschichtete Gleitpaarungen nicht nur leistungsfähiger und noch langlebiger, sondern begünstigen zusätzlich auch die Eliminierung umweltschädlicher Schmierstoffe sowie beachtliche Reduktionen bezüglich Schmiermittelverbrauch und Reibungsverlust.

Die erfindungsgemäß über die ganze Schichtoberfläche verteilten Flachmulden ähneln in der Funktion jenen Strukturen, wie sie im Maschinenbau an hochbelasteten, langlebigen Grauguß-Gleitführungen in Form von Schabemustern hinreichend bekannt sind. Im Gegensatz zu diesen relativ großflächigen Schabestrukturen sind die erfindungsgemäßen Flachmulden jedoch tiefenmäßig um etwa eine Größenordnung, flächenmäßig jedoch um ca. fünf Größenordnungen kleiner, so daß sich auf 1 $cm^2$ Hartstofffläche etwa 100.000 bis max. 1 Million Flachmulden unterbringen lassen. Eine solche feinstrukturierte Topografie könnte selbst im unbeschichteten Zustand durch mechanische Methoden, z.B. durch Schaben oder Kugelstrahlen, nicht hergestellt werden, sondern allein nur durch die erfindungsgemäße, spezielle substratorientierte Prozeßführung, gestützt auf die unmittelbar vor und während der Schichtabscheidung durchgeführte chemische Variation der Schichtbildungs- und Aufwachsbedingungen.

Als besonders hilfreich und wirkungsvoll erweist sich dabei, wenn man den Beschichtungsprozeß auf die spezifischen Reaktionsmöglichkeiten des Substrates so abstimmt, daß Kristallitflächen, Korngrenzen und Korngrenzen-Stoßstellen unterschiedlich aktiviert werden. Dies gestattet, speziell die Keimbildungsdichte längs der Korngrenzen gezielt zu variieren und den Beginn der Schichtbildung sowie das Schichtwachstum über dem jeweiligen Substratkristall entsprechend zu beeinflussen. Höhere Keimkonzentrationen längs der Korngrenzen und vor allem in deren Stoßstellen begünstigen das Schichtwachstum, so daß über den Korngrenzen und vor allem über deren Stoßstellen die Schicht dicker abgeschieden werden kann.

Den Substratkristallen kommt insofern also eine wichtige schichtstrukturierende Funktion zu, als ihre durchschnittliche Größe nicht nur die flächige Ausdehnung der Flachmulden bestimmt, sondern vor allem die flächenspezifische Flachmuldendichte (Anzahl der Flachmulden/cm$^2$) als Funktion der Kristallitmenge in der zu beschichtenden Substratfläche vorgibt. Allerdings bilden sich infolge unterschiedlicher Kristallitgrößen sowie lateraler Diffusions- und Anlagerungsvorgänge - vor allem während des Schichtbildungsbeginns - nicht gleichviele Flachmulden, wie es die Zahl der Substratkristalle in der Substratoberfläche, dem sogenannten Haftgrund, zunächst erwarten ließe. Daher liegt in der Regel die Flachmuldendichte stets bei niedrigeren Werten. In erster Näherung läßt sich die Beziehung zwischen Flachmuldendichte und mittlerer Substratkorngröße - bei Werkzeugstählen bevorzugt bestimmt als Snyder-Graff-Zahl (gemittelte Zahl der Substratkristalle über 5 $\mu$Inch Länge) - wie folgt darstellen:

$$\text{Flachmuldendichte} \approx 10^4 \times (\text{Snyder-Graff-Zahl})^{3/2} - [\text{Flachmuldendichte/cm}^2]$$

Somit beträgt bei Substratwerkstoffen mit Snyder-Graff-Zahl = 8 die Flachmuldendichte ca. 160.000, mit Snyder-Graff-Zahl = 16 die Flachmuldendichte ca. 640.000 und mit Snyder-Graff-Zahl = 22 die Flachmuldendichte ca. 1 Million Flachmulden je cm$^2$.

Da bei vielen Werkzeugstählen die Korngröße, d.h. die Größe der Substratkristalle - abhängig von den speziellen Bedingungen der Wärmebehandlung - in gewissem Rahmen beeinflußbar ist, kann die Flachmuldendichte sowohl durch eine vorausgehende Härtungsbehandlung wie auch durch die thermischen Bedingungen des CVD-Prozesses selbst in gewissen Grenzen beeinflußt werden. Vorzugsweise sollte dabei jedoch auf Kornfeinheit, als auch auf hohe Snyder-Graff-Zahl (maximal bis Snyder-Graff-Zahl = 22) geachtet werden, was sowohl der Gefügezähigkeit als auch einer hohen Flachmuldenzahl und somit auch den Gleit-Trenneffekten zugute kommt.

Die Wachstumsdifferenzen über dem jeweiligen Substratkristall können durch überlagerte Korngrenzendiffusion sowie durch spezifische Doppel- oder Mehrfachschichten verstärkt werden, z.B. indem man die substratnächste Hartstoffschicht aus Hartstoffen mit spezifischer Keimdichteempfindlichkeit aufwachsen läßt und zusätzlich unterschiedliches, korngrenzenorientiertes Wachstum durch geeignetes, sequentiell unterschiedliches Angebot der diffusionsfähigen Leichtelemente C, N, B, O fördert. In den anschließenden Schichten können diese Effekte modifiziert werden, so daß zum Beispiel eine schmierstofftechnisch äußerst günstige Topografie resultiert. Über den Korngrenzenstoßstellen bilden sich infolge rascheren Wachstums Flachkuppen, optimalerweise mit einer Überhöhung bis zu etwa 25% bis 40% der Gesamtschichtstärke (über der Kornmitte gemessen) und längs der Korngrenzen flachwellige Schwellen, die in der Regel nur halb so hoch überhöht sind wie die Flachkuppen.

Die durch zweckmäßige Kombination zusätzlicher Schichten mögliche Variation der Oberflächentopografie hat den Vorteil, die Flachmuldenform konturengetreu beizubehalten bzw. gezielt zu überhöhen oder abzuschwächen, um je nach Anwendungsfall optimale Oberflächentopografie zu erreichen.

Dank dieser korngrenzenspezifischen Schichtbildungsreaktionen entstehen die Flachmulden, welche hydrodynamisch als Mikroschmierdepots außerordentlich wirksam und insbesondere bei Mischreibung von hoher trennflächentechnischer Bedeutung sind. Diese Schmiermitteldepots erhöhen vorteilhafterweise den hydrostatisch-hydrodynamischen Traganteil, reduzieren die spezifische Festkörperreibung, erniedrigen die gesamthaft resultierende Reibkraft und steigern den Wirkungsgrad der Gleitpaarung.

Da die Flachmulden- bzw. Mikro-Schmierdepots über flachwellige Überstromschwellen kanalartig miteinander verbunden sind, ist in Gegenwart fließfähiger Schmierstoffe ein gedämpfter Druckausgleich sowie laminare Mikroströmung um die zwischen den Flachmulden liegenden Flachkuppen herum - vorwiegend in Gleitrichtung - ermöglicht. Dabei übernehmen die Überstromschwellen eine vorteilhafte, ventilartige Drosselfunktion, derzufolge das Schmiermittel im Schmierspalt unter lokal ansteigender Last nicht so rasch verdrängt werden kann, wie dies in mehr oder weniger glatten Gleitflächen über größere Oberflächenbereiche hinweg zu beobachten ist, unmittelbar gefolgt von schädigender, lokal wirkender Trockenreibung. Die erfindungsgemäße Topografie fördert also eine großflächig gleichmäßige Schmiermittel- und Druckverteilung, wobei die ungerichteten Ausgleichsströmungen zwischen benachbarten Flachmulden von einer richtungsbestimmenden Mikroströmung überlagert werden, die durch den am Gleitpartner haftenden Schmierstoff hervorgerufen wird.

Infolge des nur wenige Mikrometer dünnen Schmierspaltes ist diese Mikroströmung laminar und sehr tragfähig. Sie umströmt die Flachkuppen in Gleitrichtung, wobei die Drosselfunktion der Überstromschwellen ein zu rasches Abfließen des Schmiermittels in Gleitrichtung verhindert, so daß ein moderater Strömungsstau in den Flachmulden wie ein "Schmierstoffkissen" hydrodynamisch wirksam wird. Dieses begünstigt auch das Einziehen des Schmiermittels in den Gleitspalt unter Bildung einer filmartigen Kontaktflächenströmung.

Der zwischen Kontaktfläche und Gleitpartner erzwungene Trenneffekt wird noch weiter verbessert, wenn die Flachkuppen auf der Anströmseite einen besonders flachen Schmierkeil bilden, bzw. besonders flachflankig ausgeführt sind. Dadurch wird ein besonders günstiger keilförmiger Schmiermitteleintrag in den Gleitspalt ermöglicht. Dadurch können die Kontaktflächen auf den Flachkuppen vorteilhafterweise besonders glatt ausgeführt werden, mit gleitungsorientierter Flächenerzeugung und mit einer Rauhtiefe Rz von deutlich unter 100 Nm. Dadurch werden für den Fall eines Festkörperkontaktes die Tragflächenanteile erhöht und die Lastspitzen erniedrigt. Die an sich erschwerte Schmiermittelhaftung auf solch glatten, keramikartigen Kontaktflächen spielt angesichts der benachbarten Flachmulden und Überstromschwellen insofern keine Rolle, als deren Oberfläche mit der erfindungsgemäßen Topografie im Rahmen der jeweiligen schichtspezifischen Abscheidungsrauhigkeit von z.B. Rz = 0,3 bis 1 $\mu$m versehen wird. Ein solcherart in den Flachmulden und Überstromschwellen "verankerter" Schmierfilm fördert die Schmierfilmspreitung auch über die glatten Flachkuppen hinweg, deren flächige Ausdehnung im Verhältnis zur Schmierfilmdicke ohnehin nicht so groß ist. Einer vorzeitigen Trockenreibung auf den Flachkuppen wird somit hilfreich begegnet, wodurch die Tragfähigkeit des Gleitsystems steigt. Da sich infolge der Reibleistung der Schmierstoff im Gleitspalt erwärmt, expandiert das Schmierstoffvolumen längs des Gleitweges, welches dank der Drosselfunktion der Überstromschwellen nur verzögert abfließt, wodurch die mit zunehmendem Gleitweg normalerweise zu befürchtende Schmierfilmverlagerung aus den Hochlastzonen nicht stattfinden kann und der hydrodynamische Traganteil sich somit mit wachsender Gleitweglänge nicht verschlechtert, eher noch verbessert. Voraussetzung dafür ist, daß die mengenmäßig äußerst geringe Mikroströmung einen entsprechenden Schmiermittelnachschub erhält. In offenen Tribosystemen genügt dann bereits ein äußerst dünner Schmierfilm auf dem Gleitpartner mit Filmdicken kleiner als die hier definierte Schmierspaltdicke, d.h. kleiner 1 - 2 $\mu$m bzw. weniger als ca. 1 - 2 g Schmierstoff pro Quadratmeter.

Die extreme Belastbarkeit der erfindungsgemäßen Topografie ist insofern besonders vorteilhaft, als unter entsprechenden Flächenpressungen sich die Kontaktflächen senkrecht zur Gleitebene nicht nur elastisch, sondern auch quasi mikroplastisch zu verformen vermögen, wobei diese mikroplastische Verformung allein im Substratwerkstoff schadensfrei erfolgt. Dieses schichttechnologisch typische Verhalten erlangt vor allem in kritischen Überlastungsfällen systemschonende Bedeutung. Es erhöht sich der Kontaktflächentraganteil unter Volumenverringerung in den Schmiermitteldepots. Da der Schmiermittelabfluß über die - nun ebenfalls verengten - Strömungsquerschnitte der Überstromschwellen gedrosselt ist, steht auch das "Schmierstoffkissen", eingefangen in den Flachmulden, unter erhöhten Druckspannungen. Eine lokale Schmiermittelverdrängung ist somit nur marginal möglich, so daß auch thixotrope Phänomene im wenigen Mikrometer dünnen Schmierspalt wirksam bzw. nutzbar werden und eine sonst unausweichliche Zerstörung der Arbeitsfläche verhindert wird.

Um diese nicht nur spezifisch viskose Eigenschaften der Schmiermittel optimal nutzbar zu machen, sondern weit darüber hinaus auch thixotrope Eigenschaften spezieller Schmierstoffe bewegungs- und pressungsabhängig sowie beliebig reversibel - entweder als Flüssigschmierfilm oder als Feststoffilm zum Zwecke extremster Gleitflächenbelastbarkeit - zu aktivieren, ist eine optimierte Flachmuldentiefe zwischen 0,5 und 4 $\mu$m Rz vorteilhaft.

Die Voraussetzung für den mikroplastischen Überlastabbau ist eine ausreichende Kavitationsbeständigkeit gegenüber pulsierenden sehr hohen hydrostatisch hydrodynamischen Drücken, welche seitens der Hartstoffschichten durch entsprechenden Schichtaufbau gewährleistet sein muß.

Es ist besonders vorteilhaft, die Hochlagen mit einer Rauhigkeit < 0.3 $\mu$m Rz zu versehen, und dieses Rauhigkeitsprofil vorzugsweise in Gleitrichtung auszuführen, da hierdurch die Schmiermittelbenetzung begünstigt wird.

Vorteilhafterweise werden die Flachmulden und deren kanalartige Vernetzungen über 80% ihrer flachmuldigen Absenkung mit einer Eigenrauhigkeit von ca. 1 $\mu$m Rz versehen, wodurch sich die Haftung und flächige Spreitung des Schmiermittels an diesen Flächen verbessert und die Schmiermittelbenetzung über der gesamten Funktionsfläche, d.h. auch auf den hochliegenden, sehr glatten Festkörperkontaktflächen, begünstigt wird.

Die vorab begründete, extreme Gleitflächenbelastbarkeit wird noch zusätzlich erhöht, wenn man auf der äußeren Schichtlage einen polaren Hartstofffilm abscheidet, welcher im Kontakt mit polaren Schmierstoffen zusätzliche Haftungs- und Spreitungvorteile bildet. Solche, z.B. auf Oxidbasis aufbauende, polare Hartstofffilme bedecken zwangsläufig natürlich auch die Kontaktflächen unter Bildung polarer Kontaktflächen. Bei entsprechenden polaren Schmierstoffen begünstigen sie hier infolge nochmals verbesserter Schmierfilmhaftung die Gleit- und Trenneigenschaften.

Werden diese oxidischen Filme aus reibungsarmen Oxiden gebildet, so resultiert der Vorteil reduzierter Reibungsverluste, sofern in den Kontaktflächen Misch- oder Trockenreibung auftritt. Dieser Vorteil kann zweckmäßigerweise auch so erreicht werden, daß die äußere Schichtlage aus einem Hartstoff besteht, welcher durch Oxidation reibungsarme Oxidfilme zu bilden vermag: In den Flachmulden als polarer Hartstofffilm und auf den Kontaktflächen als polare Kontaktfläche. In diesem Fall ist die zusätzliche Abscheidung eines eigenständigen polaren Hartstofffilmes bzw. einer polaren Kontaktfläche nicht erforderlich.

Diese Lösung, d.h. nachträgliche Oxidation der äußeren Schichtlage unter Bildung eines reibungssarmen, oxidischen, polaren Hartstoffgrenzfilmes, hat den Vorteil, daß bei allmählicher, mischreibungsbedingter Abnutzung des Kontaktflächenfilms stets neue Oxidfilme infolge Tribooxidation aus der äußeren Hartstoffschicht aufwachsen und somit der günstige Reibungszustand über lange Zeit, d.h. bis zur völligen Einebnung der Flachkuppen und darüber hinaus, unverändert bleibt.

Hierzu ist es besonders vorteilhaft, Hartstoffschichten auf Titanbasis, z.B. als TiC, TiN oder auf TiCN, abzuscheiden, welche infolge Tribooxidation entsprechende Filme aus Titan-Oxikarbid, -Oxinitrid, -Oxikarbonitrid und -Oxid bilden, da diese Titan-basierten oxidischen Hartstoffphasen, insbesondere $TiO_2$, im Vergleich zu anderen Oxidfilmen signifikant niedrigere Reibzahlen aufweisen.

Der erfindungsgemäße hydrodynamisch hochaktive, schmierfilmstützende und äußerst gleitgünstige Hartstoffschichtaufbau ist nicht nur weit über bisher bekannte Grenzen der Gleitflächentragfähigkeit belastbar - bei ungewöhnlich hoher Verschleißfestigkeit und Lebensdauer. Er bietet aufgrund des idealen Zusammenspiels zwischen günstiger Mikrotopografie, Mikrohydrodynamik, mikroplastischer Defekttoleranz und nachwachsender reibungsarmer Grenzflächenfilme auch eine bisher nicht registrierte Gleit- und Notlaufsicherheit mit signifikant verringerten Reibverlusten und systemimmenenter Tribostabilität. Dies gilt insbesondere bei sonst zerstörend wirkender Überbeanspruchung. Dank dieser "Architektur" erlaubt dieser dreidimensional stukturierte Schichtaufbau auch eine drastische Reduktion der sich verschärfenden Schmierstoffprobleme durch Elimination toxischer oder umweltwidriger Schmierstoffkomponenten und durch verringerten Schmierstoffeinsatz. Dies ist gerade bei offenen Tribosystemen von umwelttechnisch und arbeitsphysiologisch herausragender Bedeutung. Diese Aspekte gewinnen bei Verlustschmierung und Entsorgung insofern noch eine beachtenswerte, zeitgemäße Komponente, als die tribologischen Leistungsreserven eines solchen Schichtaufbaus die Entwicklung innovativer Schmierstoffe, z.B. auf pflanzlicher Basis, eher zu tolerieren in der Lage sind und somit den beschleunigten Einsatz der Umwelt ureigenste, nachwachsende Stoffe mit besonders kurzem Stoffkreislauf fördern. Bei einer solchen Gleitpaarung kann ein thixotroper Schmierstoff (auf pflanzlicher Basis) mit einer Korrosionsschutzwirkung benutzt werden, wobei der Schmierstoff polar ist und auf Oberflächen aus $TiO_2$, TiOC, TiON, TiCNO, sehr gut und langzeithaftende 0,5 bis 2 $\mu$m dicke Schmierfilme bildet, die je nach Temperatur und Belastung in Flüssig- oder Feststoffphase vorliegen.

Im folgenden ist zur weiteren Erläuterung und zum besseren Verständnis ein Ausführungsbeispiel der Erfindung unter Bezugnahme auf die beigefügten Zeichnungen näher erläutert. Es zeigen:

Fig. 1　　eine schematische Darstellung eines Schnitts durch ein erfindungsgemäßes Gleitlager mit mehreren Hartstoffschichten,

Fig. 2　　eine schematische Draufsicht auf ein erfindungsgemäßes Gleitlager,

Fig. 3　　einen Schnitt längs der Linie B-B nach Fig. 2, und

Fig. 4　　einen Schnitt längs der Line A-A nach Fig. 2.

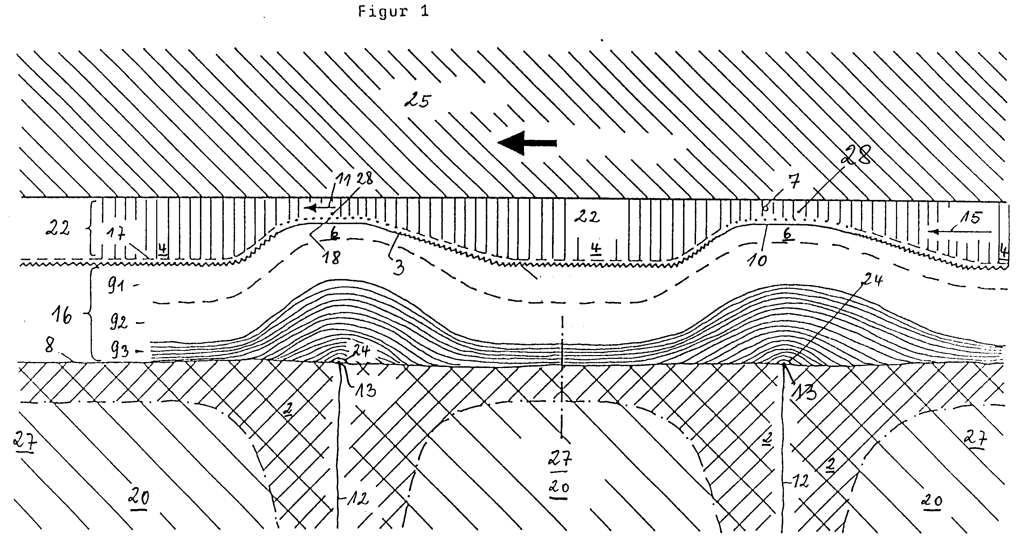

Wie aus Fig. 1 ersichtlich, besteht ein Substrat, hier härtbarer Stahl, aus einzelnen schematisch dargestellten Substratkristallen 20, die durch Korngrenzen 12 voneinander getrennt sind. An der Oberfläche des Substrats 27 ist eine erste Hartstoffschicht 93 auf einem Haftgrund 8 durch unterschiedlich rasches Wachstum der Hartstoffschicht 93 wellenförmig aufgebracht. Die flachen Flachkuppen 6 liegen dabei über den Korngrenzenstoßstellen 13 - Stelle an der mindestens drei Substratkristalle 20 zusammenstoßen - und in deren Mitte liegt das Zentrum der Keimbildung 24. Die oberste Schicht des Substrats 27 ist hierbei schematisch als Diffusionszone 2 dargestellt. Über der ersten Hartstoffschicht 93 liegen zwei weitere Hartstoffschichten 91, 92, die zusammen mit der ersten Hartstoffschicht 93 den Mehrlagenhartstoffschichtaufbau 16 bilden. Auf der äußersten Hartstoffschicht 91 ist in diesem Ausführungsbeispiel ein polarer Hartstofffilm 17 (rauh) bzw. 18 (glatt) aufgetragen. Darüber ist schematisch der Schmierspalt 22 angedeutet, der durch den Spalt zwischen äußerster Hartstoffschicht 91 mit darauf aufgebrachtem polaren Hartstoffilm 17 bzw. 18 und einem Gleitpartner 25 gebildet wird.

Eine Kontaktfläche 10 ist durch die äußere Oberfläche der Hartstoffschicht 91 und darauf aufgebrachtem polaren Hartstoffilm 18 gekennzeichnet. Jeweils ein Gleitspalt 7 wird durch die Flachkuppen 6 und den Gleitpartner 25 gebildet. Die der Gleitrichtung 26 zugewandte Flanke 3 ist dabei flach ansteigend, keilförmig ausgebildet.

In tiefer liegenden Bereichen der äußersten Harstoffschicht 91 ist die Oberfläche 19 rauher ausgeführt als auf den Flachkuppen 6, welche eine sehr gute Glättung 28 in Gleitrichtung 26 aufweisen.

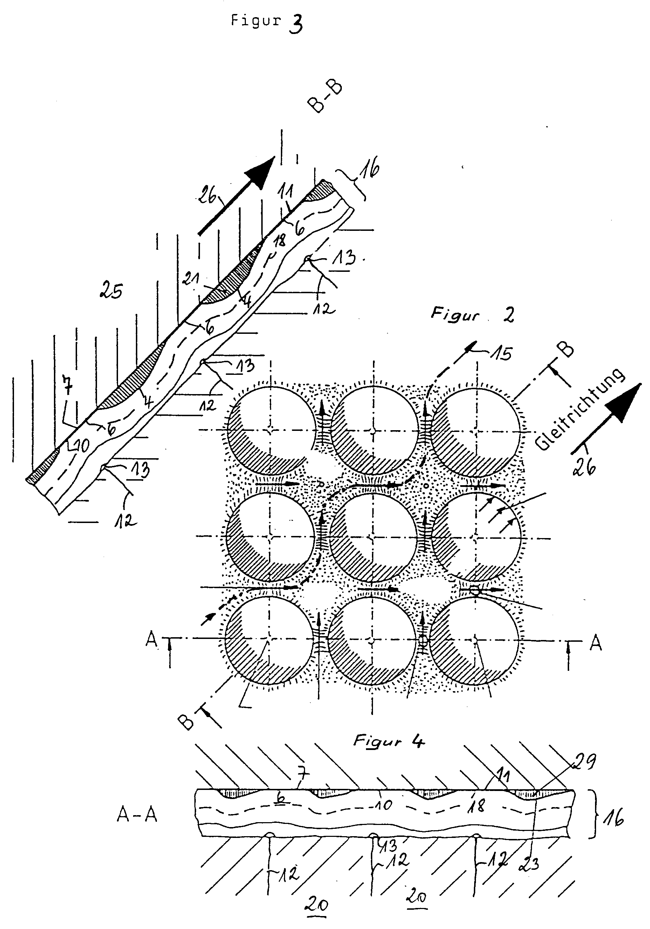

Aus der rein schematischen Darstellung in Fig. 2 geht hervor, daß die Flachkuppen 6 die Flachmulden 4 begrenzen, wobei in der Regel vier, bisweilen aber auch drei oder fünf Flachkuppen 6 jeweils eine Flachmulde 4 über der Kornmitte 14 definieren.

Der Schnitt B-B nach Fig. 2 liegt parallel zur Gleitrichtung 26 und ist in Fig. 3 dargestellt. Im Belastungsfall, wie in Fig. 3 dargestellt, ist der Gleitspalt 7 nur noch angedeutet. Es wird ersichtlich, daß Schmiermitteldepots 21 zwischen den Flachkuppen 6 liegen.

Die Flachmulden 4 bzw. die Schmiermitteldepots 21 sind über flachwellige Überstromschwellen 23 kanalartig miteinander verbunden.

Gleitet ein Gleitpartner 25 in Gleitrichtung 26 über das erfindungsgemäße Werkzeug mit dem schmierfilmstützenden, hydrodynamisch hochaktiven Hartstoffschichtaufbau hinweg, so werden ungerichtete Ausgleichsströmungen 23 zwischen benachbarten Flachmulden 4 bzw. Schmiermitteldepots 21 durch die richtungsbestimmende Gleitbewegung 15 überlagert. Infolge des am Gleitpartner 25 haftenden Schmierstoffes überwiegt die laminare Mikroströmung 15, welche die Flachkuppen 6 in Gleitrichtung umströmt. Die in Fig. 4 dargestellten Überstromschwellen 23 üben infolge der Querschnittsverengung 28 eine Drosselfunktion aus, welche ein zu rasches Abfließen des Schmiermittels in Gleitrichtung, aber auch in alle übrigen Richtungen, verhindert. Hierdurch wird das Einziehen des Schmiermittels über die flache Flanke 3 in den Gleitspalt 7 unter Bildung einer filmartigen Kontaktflächenströmung 11 begünstigt.

Dieser Effekt verstärkt sich mit zunehmender Gleitweglänge infolge reibungsbedingter Schmiermittelerwärmung dank entsprechender Volumenexpansion des Schmiermittels, ohne daß das Schmiermittel verdrängt werden kann.

Fig. 4 läßt folgern, daß mit wachsender Flächenbelastung die Flachkuppen 6 elastisch nachgeben und somit die Überströmquerschnitte 29 drosselartig verkleinert werden, wodurch der Druck in den Schmiermitteldepots 21 zunimmt und der hydrodynamische Traganteil verbessert wird.

## Patentansprüche

1. Werkzeug mit hochbelastbaren Wirk(Arbeits-)flächen, mit mindestens einer
   - auf härtbarem Stahl,
   - mittels eines Hochtemperatur-CVD-Verfahrens aufgebrachter,
   - Hartstoffschicht, bestehend aus
   - Karbiden, Nitriden, Boriden, Oxiden der Metalle der IV. bis VI. Gruppe des periodischen Systems in beliebiger Zusammensetzung,
   - einer mit Kohlenstoff und/oder Stickstoff und/oder Bor angereicherter Diffusionszone im härtbaren Stahl, die unmittelbar unter der mindestens einen aufgebrachten Hartstoffschicht liegt, wobei
   - die mindestens eine Hartstoffschicht durch differenzierte Keimbildungsdichte in der Diffusionszone (längs unterschiedlich aktivierter Korngrenzen), unterschiedlich rasch aufwächst, wodurch sich
   - etwa 100.000 bis 1 Million mikroskopisch kleine Flachmulden pro Quadratzentimeter bilden, deren Tiefe ca. 25% bis 40% der Gesamtschichtstärke, maximal jedoch 3 bis 4 $\mu$m, beträgt und deren flächige Ausdehnung etwa 300 $\mu$m$^2$ bis 30 $\mu$m$^2$ umfaßt.

2. Werkzeug nach Anspruch 1, dadurch gekennzeichnet, daß das die Zahl der Flachmulden bestimmende Wachstum der mindestens einen Hartstoffschicht von der Korngröße des Stahls abhängt und die Flachmuldendichte sich abhängig von der Snyder-Graff-Zahl $10^4$ x (Snyder-Graff-Zahl)$^{3/2}$ ermittelt, mit einer nutzbaren Obergrenze von ca. 1 Million Flachmulden je cm$^2$ beschichteter Oberfläche bei etwa 30 $\mu$m$^2$ flächiger Ausdehnung, oder ca. 100.000 Flachmulden bei ca. 300 $\mu$m$^2$ Flächengröße.

3. Werkzeug nach Anspruch 1, dadurch gekennzeichnet, daß durch zweckmäßige Kombination zusätzlicher Schichten die Flachmuldenform konturengetreu beibehalten bzw. gezielt überhöht oder abgeschwächt ist.

4. Werkzeug nach Anspruch 1, dadurch gekennzeichnet, daß in Gegenwart flüssiger oder fester Schmierstoffe in den Flachmulden Schmiermitteldepots gebildet sind.

5. Werkzeug nach Anspruch 1, dadurch gekennzeichnet, daß die Flachmulden durch Überstromschwellen miteinander netzartig verbunden sind.

6. Werkzeug nach Anspruch 1, dadurch gekennzeichnet, daß die Flachmulden in Strömungsrichtung besonders flachflankig ausgeführt sind.

7. Werkzeug nach Anspruch 5, dadurch gekennzeichnet, daß das spezifische Schmierstoffvolumen durch eine laminare Mikroströmung um Flachkuppen herum infolge reibungsbedingter thermischer Ausdehnung und dank Flachmuldenvernetzung und drosselartiger Überstromschwellen in Gleitrichtung stetig zunimmt.

8. Werkzeug nach Anspruch 1, dadurch gekennzeichnet, daß die Flachmuldentiefe auch derart optimiert werden kann, daß nicht nur spezifische Viskoseeigenschaften der Schmiermittel optimal nutzbar werden, sondern weit darüber hinaus die thixotropen Eigenschaften spezieller Schmierstoffe pressungsabhängig und beliebig reversibel - entweder als Flüssigschmierfilm oder als lokaler Feststoffilm - zum Zwecke extremster Gleitflächenbelastbarkeit und höchster Schmierfilmkonsistenz nutzbar sind.

9. Werkzeug nach Anspruch 1, dadurch gekennzeichnet, daß die Rauhigkeit auf den Hochlagen kleiner 0,3 $\mu$m Rz ist und das Rauhigkeitsprofil vorzugsweise in Gleitrichtung weist.

10. Werkzeug nach Anspruch 1, dadurch gekennzeichnet, daß die Flachmulden und deren kanalartige Vernetzungen über 80% ihrer flachmuldigen Absenkung eine Eigenrauhigkeit von ca. 1,0 $\mu$m Rz aufweisen.

11. Werkzeug nach Anspruch 10, dadurch gekennzeichnet, daß die Grenzflächen in den Flachmulden und in deren kanalartig vernetzten Überstromschwellen mit polaren Grenzfilmen belegt sind.

12. Werkzeug nach Anspruch 11, dadurch gekennzeichnet, daß auch die hochliegenden Kontaktflächen mit polaren Filmen belegt sind, welche die Benetzbarkeit fördern.

13. Werkzeug nach Anspruch 12, dadurch gekennzeichnet, daß die Filme auf den Flachkuppen auch aus den reibungsarmen Oxiden der äußeren Schichtlage, vorzugsweise aus $TiO_2$ bestehen und sich diese Filme durch Tribo-Oxidation in dem Maße ständig neu bilden, wie sie durch Verschleiß abgetragen werden.

14. Werkzeug nach Anspruch 1, dadurch gekennzeichnet, daß die Anordnung von Flachmulden, kanalartigen Vernetzungen, Hydrodynamik, Festkörpertraganteil, laminare Mikroströmung und Kontaktflächenströmung im Gleitspalt so optimiert werden können, daß in einem offenen Tribo-System keine Zusatzschmierung erforderlich ist, sofern der Gleitpartner einen Schmierfilm von ca. 1 - 2 $\mu$m Dicke (entspricht 1 - 2 g/m$^2$) kontinuierlich einträgt.

Figur 1

Figur 3

Figur 2

Gleitrichtung

Figur 4

A-A

Europäisches
Patentamt

**EUROPÄISCHER RECHERCHENBERICHT**

Nummer der Anmeldung

EP    93 10 7142

## EINSCHLÄGIGE DOKUMENTE

| Kategorie | Kennzeichnung des Dokuments mit Angabe, soweit erforderlich, der maßgeblichen Teile | Betrifft Anspruch | KLASSIFIKATION DER ANMELDUNG (Int. Cl.5) |
|---|---|---|---|
| A | NIKU-LARI A. (EDITOR) 'Advances in surface treatments' 1984 , PERGAMON PRESS LTD. , OXFORD, GB * Seite 139 - Seite 145 * --- | 1 | C23C16/00 |
| A | PATENT ABSTRACTS OF JAPAN vol. 16, no. 464 (M-1316)28. September 1992 & JP-A-41 64 504 ( NIPPON STEEL CORP ) 10. Juni 1992 * Zusammenfassung * --- | 1 | |
| A | DATABASE WPI Week 8348, Derwent Publications Ltd., London, GB; AN 83-830587 & JP-A-58 181 863 (SUMITOMO ELEC IND KK) 24. Oktober 1983 * Zusammenfassung * --- | 1 | |
| A | US-A-4 096 075 (NAKAMURA) ----- | | **RECHERCHIERTE SACHGEBIETE (Int. Cl.5)** C23C F16C |

Der vorliegende Recherchenbericht wurde für alle Patentansprüche erstellt

| Recherchenort | Abschlußdatum der Recherche | Prüfer |
|---|---|---|
| BERLIN | 30 SEPTEMBER 1993 | SMITH C. |